# EUROPEAN PATENT APPLICATION

(11) **EP 3 428 982 A1**
(43) Date of publication of application: **16.01.2019**
(21) Application number: 17762762.7
(22) Date of filing: 31.01.2017
(51) Int. Cl.: H01L 35/32, H01L 35/22, H01L 51/00, H01L 51/30, H02N 11/00

(54) **THERMOELECTRIC CONVERSION ELEMENT**

(30) Priority: 10.03.2016 JP 2016046669; 01.07.2016 JP 2016131919
(71) Applicant: Tatsuta Electric Wire & Cable Co., Ltd., Higashiosaka-shi, Osaka 578-8585 (JP)
(72) Inventor: TAKEMURA, Naoto, Kizugawa-shi Kyoto 619-0216 (JP)
(74) Representative: Schmidt, Steffen J.
(86) International application number: PCT/JP2017/003387
(87) International publication number: WO 2017/154416

(57) **Abstract**

An object of the present invention is to provide a thermoelectric transducer capable of achieving excellent output. The present invention provides a thermoelectric transducer including a strip, the strip having a specific configuration and flexibility.

## Description

### CROSS-REFERENCE TO RELATED APPLICATION

This application claims priority to Japanese Patent Application Nos. 2016-046669 and 2016-131919, the disclosures of which are incorporated herein by reference in their entirety.

### FIELD

The present invention relates to a thermoelectric transducer, more specifically, to a thermoelectric transducer having a layer structure in which a plurality of thermoelectric conversion layers formed by thermoelectric conversion materials are stacked.

### BACKGROUND

In recent years, thermoelectric transducers capable of converting thermal energy to electric energy are used for various applications. Thermoelectric transducers can convert thermal energy to electric energy and are therefore used, for example, as the main members of power generators or temperature measurement devices. Further, thermoelectric transducers can directly convert thermal energy to electric energy and therefore can simplify the configurations of the aforementioned devices. As thermoelectric transducers of this type, there are known thermoelectric transducers which include p-type devices and n-type devices formed by thermoelectric conversion materials and in which the n-type devices and the p-type devices are electrically connected to each other. In such a thermoelectric transducer including p-type devices and n-type devices, it is difficult to obtain high electromotive force by forming only one pair of a p-type device and an n-type device. Therefore, the thermoelectric transducers of this type are generally used by connecting a plurality of pairs in series. The thermoelectric transducers of this type are referred to also as bipolar-type devices since p-type devices and n-type devices are used in pairs. As the thermoelectric transducers, there are also known unileg-type thermoelectric transducers in which only p-type devices or n-type devices are connected in series.

As the thermoelectric transducers including p-type devices and n-type devices, there are known sheet-type devices in which p-type devices and n-type devices in the form of sheets are arrayed longitudinally and laterally in the plane direction, and stack-type devices in which p-type devices and n-type devices in the form of sheets are alternately stacked in the thickness direction. As the former sheet-type devices, there are known sheet-type devices in which p-type devices and n-type devices are connected to each other so as to be alternately aligned along a conductive path. The latter stack-type devices generally include a stack in which p-type devices and n-type devices are alternately stacked. When the stacking direction is referred to as the height direction of the stack, and a direction orthogonal to the height direction is referred to as the width direction of the stack, the stack-type devices are used with one end in the width direction of the stack being in contact with a heating element. The stack-type devices have an advantage that high electromotive force is easily obtained because a temperature difference is easily generated between the one end and the other end in the width direction of the stack. Therefore, in the stack-type devices, high output is easily obtained, despite of their compactness compared with the sheet-type devices, and electric energy is easily extracted from the heating element, even if the heating element is small.

In both stack-type devices of bipolar type and unileg type, layers adjacent in the stacking direction are electrically connected to each other so that directions of the voltages generated within the devices due to the temperature difference are aligned in one direction of the conductive path. As the stack-type devices, there is a known device having a stack formed by an inorganic sintered body, for example, as disclosed in Patent Literature 1.

### CITATION LIST

### Patent Literature

Patent Literature 1: Japanese re-publication of WO 2012/011334

### SUMMARY

### Technical Problem

Meanwhile, stack-type devices require, for example, to increase the size of devices, in order to increase the electric energy extracted from the heating element while the number of stacked layers is maintained. However, it is difficult to fabricate large inorganic sintered bodies. Therefore, stack-type devices have a problem that it is difficult to improve the output. Therefore, it is an object of the present invention to solve such a problem.

### Solution to Problem

As a result of diligent studies, the inventor has found that the aforementioned problem can be solved by forming stack bodies into a strip and imparting flexibility to the strip, for example, by using organic sheets as thermoelectric conversion materials, thereby accomplishing the present invention.

That is, the present invention provides a thermoelectric transducer including a strip configured to perform thermoelectric conversion, wherein the strip includes a plurality of thermoelectric conversion layers each formed by a strip-shaped thermoelectric conversion material and has a layer structure in which the plurality of thermoelectric conversion layers are stacked, each adjacent ones of the thermoelectric conversion layers in the stacking direction are electrically connected to each other to form a conductive path passing through the plurality of thermoelectric conversion layers, the plurality of thermoelectric conversion layers are electrically connected so that, when a temperature difference is provided between one end side and the other end side in the width direction of the strip, a potential difference occurs therebetween, and directions of voltages generated due to the potential difference are aligned in one direction of the conductive path, and the strip has flexibility.

In the thermoelectric transducer according to the present invention, it is preferable that the strip include a plurality of p-type layers and a plurality of n-type layers as the thermoelectric conversion layers and have a layer structure in which the p-type layers and the n-type layers are alternately stacked, each adjacent ones of the p-type layers and the n-type layers in the stacking direction be electrically connected at either end in the width direction, and the connected points be arranged along the stacking direction alternately on one end side and the other end side in the width direction.

### BRIEF DESCRIPTION OF DRAWINGS

Fig. 1 is a schematic perspective view showing a strip (wound body) constituting the body of a thermoelectric transducer.
Fig. 2 is a cross-sectional view as seen from the direction of arrows II-II' in Fig. 1.
Fig. 3 is a schematic sectional view of a thermoelectric transducer according to another embodiment.

### DESCRIPTION OF EMBODIMENTS

Embodiments according to a thermoelectric transducer of the present invention will be described. A thermoelectric transducer of this embodiment is used for converting thermal energy to electric energy. Further, the thermoelectric transducer of this embodiment can be used for converting electric energy to thermal energy. The thermoelectric transducer of the present invention includes a plurality of thermoelectric conversion layers formed by strip-shaped thermoelectric conversion materials. The thermoelectric transducer of the present invention has a layer structure in which the plurality of thermoelectric conversion layers are stacked. In the thermoelectric transducer of the present invention, the thermoelectric conversion layers adjacent in the stacking direction are electrically connected to each other to form a conductive path passing through the plurality of thermoelectric conversion layers. Moreover, the plurality of thermoelectric conversion layers in the present invention are electrically connected so that a potential difference occurs in each thermoelectric conversion layer when a temperature difference is provided between one end side and the other end side in the width direction of the strip, and directions of voltages generated due to the potential difference are aligned in one direction of the conductive path. Further, in the thermoelectric transducer of the present invention, the strip has flexibility.

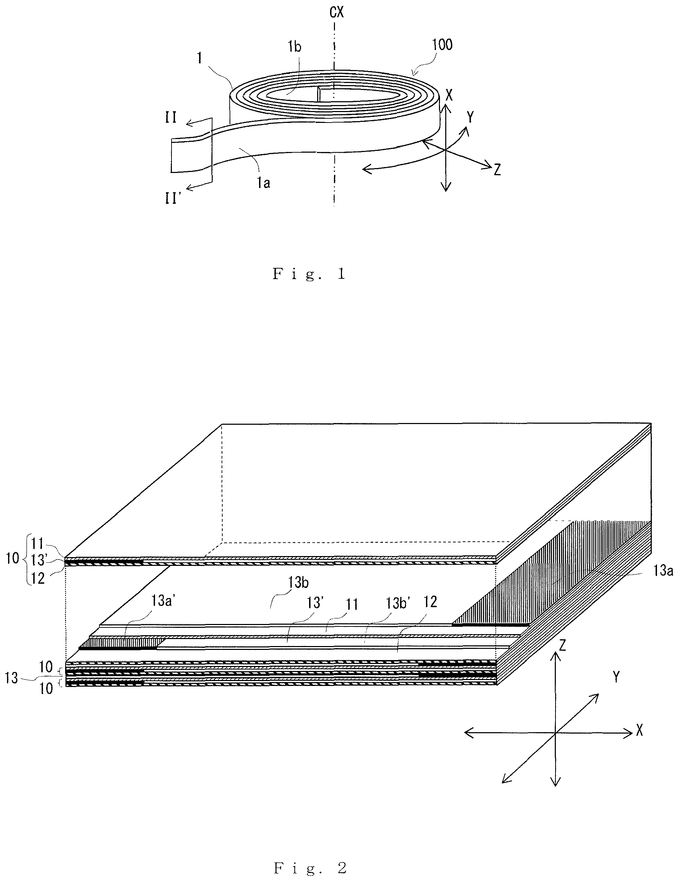

Hereinafter, as a first embodiment of the thermoelectric transducer, a bipolar-type thermoelectric transducer including both p-type layers and n-type layers as the thermoelectric conversion layers will be described. The thermoelectric transducer of the first embodiment is used for converting thermal energy to electric energy in a compact form. As shown in Fig. 1, in the thermoelectric transducer of this embodiment, a body 100 configured to perform thermoelectric conversion is constituted by a strip 1 wound into a roll. That is, the strip 1 of this embodiment has flexibility that allows winding. In the thermoelectric transducer of this embodiment, the body 100 is constituted by a wound body formed by winding the strip 1 around a winding axis CX.

As shown in Fig. 1, the body 100 in this embodiment has a hollow disk shape (donut shape). One of two surfaces, the upper surface side and the lower surface side in Fig. 1, of the body 100 in this embodiment serves as a heat receiving surface that receives heat from a heat source. The body 100 generates a potential by utilizing the temperature difference between the heat receiving surface and the other surface that is opposite to the heat receiving surface.

As shown in Fig. 2, the strip 1 constituting the body 100 has a layer structure. In the following description, the dimension of the body 100 along the direction of the winding axis CX may be referred to as the "height" of the body 100. Further, the dimension of the strip 1 along the direction of the winding axis CX may be referred to as the "width" of the strip 1. That is, in the following description, the direction of "arrow X" in Figs. 1 and 2 may be referred to as the "height direction" of the body 100 or the "width direction" of the strip 1. Further, in the following description, the direction of "arrow Y" in Figs. 1 and 2 may be referred to as the "circumferential direction" of the body 100 or the "length direction" of the strip 1. Further, in the following description, the direction of "arrow Z" in Figs. 1 and 2 may be referred to as the "radial direction" of the body 100 or the "thickness direction" of the strip 1.

As shown in Fig. 2, the strip 1 has a layer structure including a plurality of p-type layers 11 constituted by strip-shaped p-type thermoelectric conversion materials and a plurality of n-type layers 12 constituted by strip-shaped n-type thermoelectric conversion materials, in which the p-type layers 11 and the n-type layers 12 are alternately stacked. The p-type thermoelectric conversion materials and the n-type thermoelectric conversion materials have a width corresponding to the width of the strip 1 and a length corresponding to the length of the strip 1. The plurality of the p-type layers 11 and the plurality of the n-type layers 12 are stacked with their both end edges in the width direction being aligned and both end edges in the length direction being aligned. That is, the strip 1 when stretched linearly is in the form of a rectangular bar having constant width and thickness in the length direction. In the strip 1, the p-type layers 11 and the n-type layers 12 that are adjacent to each other in the stacking direction (Y direction) are electrically connected at either end in the width direction (X direction), and the connection points are alternately arranged on one end side and on the other end side in the width direction in the stacking direction.

The strip 1 further includes adhesive layers 13 formed by strip-shaped adhesive materials. The strip 1 has pair parts 10 including the p-type layers 11 and the n-type layers 12 that are electrically connected at either end in the width direction. Each adhesive layer 13 is interposed between one pair part 10 and another pair part 10 that is adjacent to the aforementioned pair part 10 in the stacking direction. The strip-shaped adhesive material constituting the adhesive layer 13 includes a conductive region constituted by an electrically conductive adhesive on one end side in the width direction. That is, the one ends in the width direction of the two pair parts 10 are bonded to each other by the adhesive layer 13 constituted by the electrically conductive adhesive. The two pair parts 10 that are adjacent to each other in the stacking direction are electrically connected at either end in the width direction by the electrically conductive adhesive constituting the adhesive layer 13 interposed therebetween. The width of the adhesive material is the same as the width of the p-type thermoelectric conversion materials and the n-type thermoelectric conversion materials. The length of the adhesive material is the same as the length of the p-type thermoelectric conversion materials and the n-type thermoelectric conversion materials. In the strip 1, the adhesive layers 13 are stacked with their end edges aligned with those of the p-type layers 11 and the n-type layers 12.

The adhesive layers 13 are formed by a different adhesive on one end side in the width direction from those on the other end side. Strip-shaped regions of the adhesive layers 13 along the one end side in the width direction are formed by an insulating adhesive, and regions thereof along the other end side in the width direction is formed by the electrically conductive adhesive. That is, the adhesive layers 13 include insulating regions 13b having electrically insulating properties on the one end side in the width direction and include conductive regions 13a having conductivity in the thickness direction on the other end side.

The width of each conductive region 13a in this embodiment is substantially uniform in the length direction of the strip 1. The width of each insulating region 13b is also substantially uniform in the length direction of the strip 1.

The strip 1 of this embodiment includes the adhesive layers 13 configured to bond the pair parts 10 together and the adhesive layers 13' configured to bond the p-type layers 11 and the n-type layers 12 in the pair parts. The adhesive layers 13' (which will be hereinafter referred to also as "in-pair adhesion layers 13'") configured to bond the p-type layers 11 and the n-type layers 12 in the pair parts include conductive regions 13a' and insulating regions 13b' in the same manner as the adhesive layers 13 configured to bond the pair parts 10 to each other (which will be hereinafter referred to as "the pair-to-pair adhesive layers 13"). That is, each pair part 10 has a layer structure in which a p-type layer and an n-type layer are stacked via an in-pair adhesion layer 13'. In the pair part 10, the p-type layer and the n-type layer are electrically connected to each other by an electrically conductive adhesive at either end in the width direction of the in-pair adhesion layer 13'.

However, whereas the pair-to-pair adhesive layers 13 have the insulating regions 13b on one end side in the width direction (X direction) of the strip 1 and the conductive regions 13a on the other end side, the in-pair adhesion layers 13' have the conductive regions 13a' on the one end side and the insulating regions 13b' on the other end side. That is, the positions of the conductive regions and the insulating regions are reversed in the pair-to-pair adhesive layers 13 and the in-pair adhesion layers 13'. In this embodiment, the pair-to-pair adhesive layers 13 and the in-pair adhesion layers 13' are alternately arranged in the stacking direction (Y direction) of the strip 1. Therefore, the points where the p-type layers 11 and the n-type layers 12 are electrically connected are alternately arranged in the stacking direction (Y direction) as described above. That is, the conductive path of the strip 1 of this embodiment "zigzags" in the stacking direction, so as to alternately pass through the p-type layers 11 and the n-type layers 12. In the case where a temperature difference is provided between one end side and the other end side in the width direction of the strip 1, the positions with relatively high potential are reversed between the p-type layers 11 and the n-type layers 12. For example, in the case where the potential is higher on one end side than on the other end side in the width direction of the p-type layers 11, the potential is higher on the other end side than on one end side in the width direction of the n-type layers 12. As described above, the p-type layers 11 and the n-type layers 12 are connected so that the conductive path zigzags in the thickness direction in the strip 1. Therefore, the strip 1 is electrically connected so that, when a temperature difference is provided between one end side and the other end side in the width direction, directions of voltages generated in the thermoelectric conversion layers are aligned in one direction of the conductive path.

The strip 1 of this embodiment can be formed, using curable liquids for forming the p-type layers 11, the n-type layers 12, and the adhesive layers 13 and 13', by a build-up method in which one of the p-type layers 11, one of the in-pair adhesion layers 13', one of the n-type layers 12, and one of the pair-to-pair adhesive layers 13 are each applied and cured in this order. However, in such a case, much time and effort may be required for fabricating the strip 1. Accordingly, the strip 1 of this embodiment is preferably formed by a method in which sheets for constituting the respective layers are prepared in advance, and the sheets are integrally stacked.

The strip 1 of this embodiment can be fabricated, for example, by a method of preparing sheets for constituting the p-type layers 11 and the n-type layers 12, forming the adhesive layers 13 and 13' on these sheets using a liquid agent, and bonding the sheets to one another using the adhesive layers. As a more specific example, the strip 1 of this embodiment can be fabricated, for example, by preparing a plurality of pieces of the in-pair adhesion layers 13' formed on the upper surfaces of first sheets for forming the p-type layers 11 and a plurality of pieces of the pair-to-pair adhesive layers 13 formed on the upper surfaces of second sheets for forming the n-type layers 12, and alternately stacking the first sheets and the second sheets via the adhesive layers 13 and 13'. At this time, the pair-to-pair adhesive layers 13 and the in-pair adhesion layers 13' are not necessarily formed separately on the first sheets and the second sheets, and the strip 1 may be formed by alternately stacking the first sheets on which no adhesive layers are formed and the second sheets on both surfaces of which the adhesive layers 13 and 13' are formed, for example.

That is, the thermoelectric transducer of this embodiment can be fabricated by performing a step of forming adhesive layers on one surfaces of both first and second sheets or on both surfaces of either one of the first and second sheets, and a step of stacking the first sheets and the second sheets to form a stack, thereby forming the strip by the stack.

The first sheets and the second sheets may be fabricated to have a width corresponding to the width of the strip 1 or a width larger than the width of the strip 1. That is, the strip 1 of this embodiment may be fabricated by alternately stacking the first sheets and the second sheets simply or by slitting the stack obtained by alternately stacking the first sheets and the second sheets into a specific width.

In the fabrication of the thermoelectric transducer of this embodiment, a plurality of strips 1 may be fabricated from one stack by forming the first sheets and the second sheets to have a width twice or more the width of the strip 1, forming the conductive regions 13a and the insulating regions 13b which are at least twice as many as the number necessary for forming the single strip 1 on the first sheets and the second sheets, and cutting the stack in which the first sheets and the second sheets are stacked, along the longitudinal direction.

The dimensions or the like of the sheets for constituting the p-type layers 11 and the n-type layers 12 are not specifically limited, but the thickness is preferably small, in order to allow the strip 1 to exert excellent flexibility by reducing the thickness of the strip 1. Specifically, the thickness of the p-type layers 11 and the n-type layers 12 is preferably 100 µm or less, more preferably 50 µm or less. However, when the thickness of the p-type layers 11 and the n-type layers 12 is excessively small, careful work is required when handling the sheets for forming these layers. Accordingly, the thickness of the p-type layers 11 and the n-type layers 12 is preferably 5 µm or more.

The materials for forming the p-type layers 11 and the n-type layers 12 are not specifically limited, but these layers can be formed, for example, by a sheet formed substantially only of carbon nanotubes, a sheet formed by a composition containing carbon nanotubes and a polymer binder, a sheet formed by an electrically conductive polymer.

Examples of the sheet formed substantially only of carbon nanotubes include bucky paper.

Carbon nanotubes (CNTs) include single layer CNTs formed by winding a piece of carbon film (graphene sheet) into a cylindrical shape, double layer CNTs formed by winding two pieces of graphene sheets concentrically, and multilayer CNTs formed by winding three or more pieces of graphene sheets concentrically. In this embodiment, the single layer CNTs, the double layer CNTs, and the multilayer CNTs may be used individually, or two or more of them may be used in combination. In particular, the p-type layers 11 and the n-type layers 12 preferably contain at least either one of the single layer CNTs and the double layer CNTs that have excellent properties such as conductivity and semiconductivity. More preferably, the p-type layers 11 and the n-type layers 12 contain the single layer CNTs.

The single layer CNTs may be semiconductive or metallic, and may have both properties in combination. In the case of using both the semiconductive CNT and the metallic CNT, the content ratio of the two in the thermoelectric conversion materials can be appropriately adjusted depending on the application. Further, the CNTs may include metals or the like, and a CNT including molecules such as fullerenes may be used. The thermoelectric conversion materials of this embodiment may contain nanocarbons such as carbon nanohorn, carbon nanocoil, and carbon nanobeads other than the CNTs.

The CNTs can be produced by arc discharge, chemical vapor deposition (which will be hereinafter referred to as CVD), laser ablation, or the like. The CNTs used in this embodiment may be obtained by any one of the methods but are preferably obtained by either one of arc discharge and CVD. In the production of the CNTs, by-products such as fullerenes, graphites, amorphous carbon are generated at the same time, and catalyst metals such as nickel, iron, cobalt, and yttrium may remain in some cases. Therefore, in the production of the CNTs, purification is preferably performed in order to remove such impurities. The method for purifying the CNTs is not specifically limited, but acid treatment using nitric acid, sulfuric acid, or the like, and ultrasonic treatment are effective to remove the impurities. In addition, separation and removal using a filter are also preferable in order to improve the purity of the CNTs.

After the purification, the obtained CNTs can be also used as the thermoelectric conversion materials as they are. Further, CNTs are generally produced in the form of yarn, which may be cut into a desired length for use depending on the application. The CNTs can be cut into the form of short fibers by acid treatment using nitric acid, sulfuric acid, or the like, ultrasonic treatment, freeze grinding, or the like.

In this embodiment, not only the cut CNTs, but also the CNTs fabricated in the form of short fibers in advance can be used in the same manner. Such CNTs in the form of short fibers can be obtained, for example, by forming a coating film of a catalyst metal such as iron and cobalt on a substrate, followed by vapor phase growth by CVD on the surface of the coating film. At that time, CNTs in the form of short fibers can be obtained by vapor phase growth by pyrolysis of carbon compounds at 700 to 900°C. In this method, the CNTs in the form of short fibers are obtained in a shape oriented in the direction perpendicular to the surface of the substrate. The thus fabricated CNTs in the form of short fibers can be extracted by a method such as peeling off the CNTs from the substrate. Further, the CNTs in the form of short fibers can be obtained also by a method of allowing a porous support such as porous silicon or an aluminum-anodized film to carry a catalyst metal and allowing CNTs to grow on the surface by CVD. The oriented CNTs in the form of short fibers can be fabricated on the substrate by performing CVD in an argon/hydrogen gas flow using a molecule such as iron phthalocyanine containing a catalyst metal in the molecule as a raw material. Further, the oriented CNTs in the form of short fibers can be formed on the surface of a SiC single crystal by epitaxial growth.

The average length of the CNTs used in this embodiment is not specifically limited and can be appropriately selected depending on the application of the thermoelectric transducer. For example, the average length of the CNTs of this embodiment is preferably 0.01 µm or more and 1,000 µm or less, more preferably 0.1 µm or more and 100 µm or less, in view of ease of production, film-forming properties, conductivity, or the like.

The diameter of the CNTs used in this embodiment is not specifically limited but is preferably 0.4 nm or more and 100 nm or less, more preferably 50 nm or less, further preferably 15 nm or less, in view of durability, transparency, film-forming properties, conductivity, or the like.

In the case where the p-type layers 11 and the n-type layers 12 are constituted by a composition containing carbon nanotubes and a polymer binder, the polymer binder is not specifically limited, but examples thereof include conjugated polymers and nonconjugated polymers. The thermoelectric conversion materials preferably contain at least one polymer compound selected from the group consisting of conjugated polymers and nonconjugated polymers as a polymer binder. In the case of containing a plurality of polymer compounds, the thermoelectric conversion materials may contain the same type of a plurality of polymer compounds or different kinds of a plurality of polymer compounds. The polymer binder preferably has at least one of the polymer compounds contained therein that is a conjugated polymer or a nonconjugated polymer. The polymer binder is preferably a mixture of at least one of conjugated polymers and at least one of nonconjugated polymers. When such a mixture is contained, the dispersibility of single layer CNTs in the thermoelectric conversion materials is easily improved.

In the case where the polymer compound is a copolymer, any one of block copolymers, random copolymers, alternating copolymers, and graft copolymers may be used. The polymer compound contained in the polymer binder may be an oligomer. The mass-average molecular weight of the polymer compound is, for example, preferably 5,000 or more, more preferably 7,000 to 300,000.

The content of the polymer compound in the p-type layers and the n-type layers, and the thermoelectric conversion materials constituting such layers is not specifically limited but is preferably 5 to 90 mass%, more preferably 10 to 80 mass%, further preferably 20 to 70 mass%, particularly preferably 20 to 60 mass%, in the total solid content, in view of the thermoelectric conversion performance or the like.

The content of conjugated polymers in the p-type layers and the n-type layers, and the thermoelectric conversion materials constituting such layers is not specifically limited but preferably falls within the range satisfying the content of the aforementioned polymer compound, in view of the thermoelectric conversion performance or the like. The content of conjugated polymers is preferably 15 to 70 mass%, more preferably 25 to 60 mass%, further preferably 30 to 50 mass%, in the total solid content, for example. Likewise, the content of nonconjugated polymers in the p-type layers and the n-type layers, and the thermoelectric conversion materials forming such layers is not specifically limited but preferably falls within the range satisfying the content of the aforementioned polymer compound, in view of the thermoelectric conversion performance. The content of nonconjugated polymers is preferably 20 to 70 mass%, more preferably 30 to 65 mass%, further preferably 35 to 60 mass%, in the total solid content, for example.

In the case where the p-type layers and the n-type layers, and the thermoelectric conversion materials forming such layers contain a conjugated polymer and a nonconjugated polymer, the content of the nonconjugated polymer is preferably 10 to 1,500 parts by mass, more preferably 30 to 1,200 parts by mass, particularly preferably 80 to 1,000 parts by mass, with respect to 100 parts by mass of the conjugated polymer.

The content ratio of the CNTs to the polymer compound (CNT:polymer compound) in the p-type layers and the n-type layers, and the thermoelectric conversion materials forming such layers is preferably 0.05:1 to 4:1, further preferably 0.1:1 to 2.3:1, on a mass basis, in view of the dispersibility of the CNTs.

The conjugated polymer is not specifically limited, as long as it is a polymer compound having a conjugation structure in which its main chain is conjugated with π electrons or a lone pair of electrons. Examples of such a conjugation structure include a structure in which single bonds and multiple bonds are alternately connected in carbon-carbon bonds on the main chain.

Examples of the conjugated polymer include conjugated polymers containing, as a repeating structure, structural components corresponding to at least one compound selected from the group consisting of thiophene compounds, pyrrole compounds, aniline compounds, acetylene compounds, p-phenylene compounds, p-phenylene vinylene compounds, p-phenylene ethynylene compounds, p-fluorenylene vinylene compounds, fluorene compounds, aromatic polyamine compounds (which are also referred to as arylamine compounds), polyacene compounds, polyphenanthrene compounds, metal phthalocyanine compounds, p-xylylene compounds, vinylene sulfide compounds, m-phenylene compounds, naphthalene vinylene compounds, p-phenylene oxide compounds, phenylene sulfide compounds, furan compounds, selenophen compounds, azo compounds, and metal complex compounds.

Among these, the conjugated polymer is preferably one containing, as a repeating structure, structural components corresponding to at least one compound selected from the group consisting of thiophene compounds, pyrrole compounds, aniline compounds, acetylene compounds, p-phenylene compounds, p-phenylene vinylene compounds, p-phenylene ethynylene compounds, fluorene compounds, and arylamine compounds, in view of the thermoelectric conversion performance.

Substituents that may be contained in each of the aforementioned compounds are not particularly limited but are preferably selected in consideration of the compatibility with other components of the thermoelectric conversion materials, the type of dispersion medium that can be used for preparing the thermoelectric conversion materials, or the like. The substituents that may be contained in each of the aforementioned compounds are preferably substituents that can enhance the dispersibility of the conjugated polymer in the dispersion medium. As such substituents, linear, branched, or cyclic alkyl groups, alkoxy groups, and thioalkyl groups can be used preferably, in the case of using an organic solvent as the dispersion medium for preparing the thermoelectric conversion materials. Other than the above, examples of preferable substituents can include alkoxyalkyleneoxy groups, alkoxyalkyleneoxyalkyl groups, crown ether groups, and aryl groups. These groups may further have substituents. Further, the number of carbons in such a substituent is not particularly limited but is preferably 1 to 12, more preferably 4 to 12. As the substituents, long-chain alkyl groups, alkoxy groups, thioalkyl groups, alkoxyalkyleneoxy groups, and alkoxyalkyleneoxyalkyl groups, which have 6 to 12 carbon atoms are particularly preferable. Meanwhile, in the case of using water or a mixed solvent containing water as the dispersion medium, the terminal groups or the substituents of each compound are preferably hydrophilic groups such as carboxy groups, sulfo groups, hydroxyl groups, and phosphate groups. The compound may have dialkylamino groups, monoalkylamino groups, amino groups, carboxy groups, acyloxy groups, alkoxycarbonyl groups, aryloxycarbonyl groups, amide groups, carbamoyl groups, nitro groups, cyano groups, isocyanate groups, isocyano groups, halogen atoms, perfluoroalkyl groups, perfluoroalkoxy groups, or the like. The number of substituents is also not particularly limited and is preferably one or more in consideration of the dispersibility and the compatibility of the conjugated polymer, the conductivity, or the like.

The nonconjugated polymer in this embodiment is a polymer compound in which the polymer main chain has no conductivity in the nonconjugated structure. Specifically, it is a polymer other than polymers in which the polymer main chain is constituted by heteroatoms having aromatic rings (such as carbocyclic aromatic rings and heteroaromatic rings), ethynylene bonds, ethenylene bonds, and lone pairs of electrons. The type of nonconjugated polymer of this embodiment is not specifically limited, and commonly known nonconjugated polymers can be used. The nonconjugated polymer preferably contains, as a repeating structure, structural components corresponding to at least one compound selected from the group consisting of vinyl compounds, (meth)acrylate compounds, carbonate compounds, ester compounds, amide compounds, imide compounds, fluorine compounds, and siloxane compounds. These compounds may have substituents. Examples of the substituents that may be contained in the compound constituting the nonconjugated polymer are the same as those shown as examples for the conjugated polymer.

In a polyvinyl compound containing structural components corresponding to a vinyl compound as a repeating structure, the vinyl compound is not specifically limited as long as it is a compound that has a carbon-carbon double bond in the molecule. Examples of the vinyl compound include styrene, vinylpyrrolidone, vinylcarbazole, vinylpyridine, vinylnaphthalene, vinylphenol, vinyl acetate, styrenesulfonic acid, vinyl alcohol, vinylarylamines such as vinyltriphenylamine, and vinyltrialkylamines such as vinyltributylamine. Further, examples of other vinyl compounds include olefins having 2 to 4 carbon atoms and corresponding to structural components of polyolefins (such as ethylene, propylene, and butene).

In poly(meth)acrylate containing structural components corresponding to a (meth)acrylate compound as a repeating structure, the (meth)acrylate compound is both or either of an acrylate compound and a methacrylate compound. Examples of the (meth)acrylate compound include acrylate monomers including: unsubstituted alkyl group-containing hydrophobic acrylates such as methyl acrylate, ethyl acrylate, propyl acrylate, and butyl acrylate; and hydroxyl group-containing acrylates such as 2-hydroxyethyl acrylate, 1-hydroxyethyl acrylate, 2-hydroxypropyl acrylate, 3-hydroxypropyl acrylate, 1-hydroxypropyl acrylate, 4-hydroxybutyl acrylate, 3-hydroxybutyl acrylate, 2-hydroxybutyl acrylate, and 1-hydroxybutyl acrylate. Further, examples of the (meth)acrylate compound include methacrylate monomers in which acryloyl groups of these acrylate monomers are substituted with methacryloyl groups.

Specific examples of polycarbonate containing structural components corresponding to a carbonate compound as a repeating structure include a general purpose polycarbonate composed of bisphenol A and phosgene, Iupizeta (product name, manufactured by MITSUBISHI GAS CHEMICAL COMPANY, INC.), and Panlite (product name, manufactured by Teijin Chemicals Ltd). Examples of a compound that forms a polyester containing structural components corresponding to an ester compound as a repeating structure include polyalcohols and hydroxy acids such as polycarboxylic acid and lactic acid. Specific examples of the polyester include Vylon (product name, manufactured by TOYOBO CO., LTD). Specific examples of a polyamide containing structural components corresponding to an amide compound as a repeating structure include PA-100 (product name, manufactured by T&K TOKA CO., LTD). Specific examples of a polyimide containing structural components corresponding to an imide compound as a repeating structure include Solpit 6,6-PI (product name, manufactured by Solpit Industries, Ltd). Examples of a fluorine compound that forms a fluororesin containing structural components corresponding to a fluorine compound as a repeating structure, specifically, include vinylidene fluoride and vinyl fluoride. Examples of a polysiloxane containing structural components corresponding to a siloxane compound as a repeating structure, specifically, include polydiphenylsiloxane and polyphenylmethylsiloxane. The nonconjugated polymer may be a homopolymer or a copolymer with each of the aforementioned compounds or the like, if possible.

In this embodiment, it is more preferable to use a nonconjugated polymer containing structural components corresponding to a vinyl compound or a carbonate compound as a repeating structure as the nonconjugated polymer.

The nonconjugated polymer is preferably hydrophobic, more preferably has no hydrophilic groups such as sulfonic acid and hydroxyl groups in the molecule. Further, the solubility parameter (SP value) of the nonconjugated polymer is preferably 11 or less. Preferable examples of the nonconjugated polymer having an SP value of 11 or less include polyvinyl compounds such as polystyrene, polyvinyl naphthalene, and polyvinyl acetate; poly(meth)acrylates such as polymethyl acrylate, ethyl acrylate, propyl acrylate, and butyl acrylate; polyesters; polyolefins such as polyethylene; polycarbonates; and fluororesins such as polyvinylidene fluoride. Among these, the nonconjugated polymer is more preferably any one of polystyrene, polyvinyl naphthalene, polymethyl acrylate, and polycarbonates.

Examples of the conductivity polymer used in the p-type layers and the n-type layers, and the thermoelectric conversion materials forming such layers include the aforementioned conjugated polymers. In particular, the conductivity polymer is preferably a linear conjugated polymer. For example, in the case of a polythiophene polymer or a polypyrrole polymer, the linear conjugated polymer is preferably obtained by bonding of the thiophene rings or the pyrrole rings at the 2- and 5-positions. For example, in the case of a poly-p-phenylene polymer, a poly-p-phenylene vinylene polymer, or a poly-p-phenylene ethynylene polymer, the linear conjugated polymer is preferably obtained by bonding of the phenylene groups at the para positions (the 1- and 4-positions).

The adhesive layers can be formed using thermosetting resin compositions or thermoplastic resin compositions. The insulating regions of the adhesive layers can be formed, for example, using thermosetting resin compositions or thermoplastic resin compositions having a volume resistivity of 1 × 10¹⁰ Ω·cm or more, preferably a volume resistivity of 1 × 10¹² Ω·cm or more. The conductive regions of the adhesive layers can be formed, for example, using thermosetting resin compositions or thermoplastic resin compositions containing conductive particles and having a volume resistivity of 1 × 10⁸ Ω·cm or less. The conductive regions and the insulating regions of the adhesive layers may have common or different resins as the main components of the resin compositions.

Examples of thermosetting resins that serve as the main components of the thermosetting resin compositions include phenolic resins, epoxy resins, urethane resins, melamine resins, and alkyd resins. One of these thermosetting resins can be used alone, or two or more of them can be used in combination.

Examples of thermoplastic resins that serve as the main components of the thermoplastic resin compositions include polystyrene resins, vinyl acetate resins, polyester resins, polyethylene resins, polypropylene resins, polyamide resins, rubber resins, and acrylic resins. One of these thermoplastic resins can be used alone, or two or more of them can be used in combination.

To these resin compositions, curing agents, tackifiers, antioxidants, pigments, dyes, plasticizers, ultraviolet absorbers, defoamers, leveling agents, fillers, flame retardants, viscosity modifiers, or the like can be added, as required.

The material of conductive particles contained in the thermosetting resin compositions or the thermoplastic resin compositions in order to allow the conductive regions to have conductivity is not specifically limited, and can employ carbon powder, silver powder, copper powder, nickel powder, solder powder, aluminum powder, silver-coated copper fillers plated with silver on copper powder, fillers plated with metal on resin balls, glass beads, or the like, or mixtures of these. The shape of the conductive particles is not specifically limited and can be appropriately selected from spherical, flat, flake, dendrite, fibrous shapes. The average particle size of the conductive particles is not specifically limited and can be set, for example, to 1 µm or more and 50 µm or less. The amount of the conductive particles to be mixed is not specifically limited, but in the case where the resin composition that forms the conductive regions is in paste form, the mass ratio in the paste is preferably 70 mass% or more and 95 mass% or less. In the case where the resin composition that forms the conductive regions is not a paste, the mass ratio of the conductive particles in the resin composition is preferably 5 mass% or more and 70 mass% or less.

The strip of this embodiment can be formed using materials other than the materials described above as examples. In order to form a more compact wound body, the strip of this embodiment preferably has a flexibility that enables one or more turns of winding around a round bar having a diameter of 20 mm or less. That is, the strip of this embodiment preferably does not have problems such as cracks or tears in each layer, even when wound one or more turns around a round bar having a diameter of 20 mm or less. Regarding this point, the strip of this embodiment more preferably has flexibility that enables one or more turns of winding around a round bar having a diameter of 10 mm or less, particularly preferably a diameter of 5 mm or less.

In this embodiment, the case where the conductive regions are formed in the regions along one end edge and the other end edge in the width direction of the strip has been described as an example, but the conductive regions are not necessarily formed in such ranges that reach the end edges as long as they are distributed more on one end side or the other end side in the width direction. That is, the end edges of the conductive regions may be located on the inner side of the end edges of the strip, so that small insulating regions are provided between the end edges of the strip and the end edges of the conductive regions, as needed. In this case, exposure of the resin compositions containing the conductive particles on the lateral surfaces of the strip is suppressed, and therefore conduction of unnecessary sites due to protrusion of the resin compositions can be suppressed, for example, when a body is formed by winding the strip.

The aforementioned examples are limited examples of the present invention, and the present invention is not limited to the aforementioned examples at all. For example, although an aspect of including adhesive layers is described as an example in this embodiment, the thermoelectric transducer of the present invention can be formed also by a strip without pair-to-pair adhesive layers or in-pair adhesion layers. As to this point, for example, in the case where the thermoelectric conversion materials constituting the p-type layers and the n-type layers themselves have adhesiveness at normal temperature or by heating, when the thermoelectric conversion materials are partly directly bonded to each other and the remaining parts are bonded via electrically insulating resin films, the directly bonded parts can be used as parts instead of the conductive regions of the adhesive layers, and the parts interposing the resin films can be used as parts instead of the insulating regions of the adhesive layers. Further, in the thermoelectric transducer of the present invention, various modifications other than such a modification can be added to the aspect described as an example.

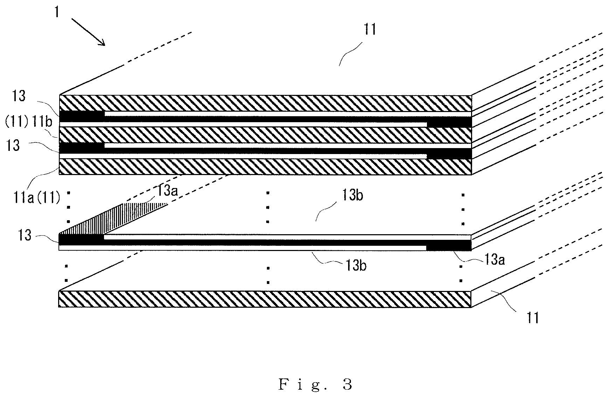

The advantages of the present invention described above are not limited to the case where the thermoelectric transducer is of bipolar-types, and are the same as in the case of unileg-types. Hereinafter, a unileg-type thermoelectric transducer will be described as a second embodiment. The thermoelectric transducer of the second embodiment is the same as the thermoelectric transducer of the first embodiment in that the body 100 includes the strip 1 configured to perform thermoelectric conversion, and the strip 1 has flexibility. As shown in Fig. 3, the strip 1 of the second embodiment includes a plurality of p-type layers 11 formed by strip-shaped thermoelectric conversion materials and has a layer structure in which the p-type layers 11 are stacked, the layer structure including the first p-type layers 11a and the second p-type layers 11b that are adjacent to each other in the stacking direction. In the first p-type layers 11a and the second p-type layers 11b, one end side in the width direction of the first p-type layers 11a and the other end side in the width direction of the second p-type layers 11b are electrically connected to each other.

In the strip 1 of the second embodiment, the second p-type layers 11b are stacked on the first p-type layers 11a via the adhesive layers 13. The adhesive layers 13 each have a three-layer structure and include insulating layers constituted by an insulating adhesive having a volume resistivity of 1 × 10¹⁰ Ω·cm or more above and below a conductive layer constituted by an electrically conductive adhesive having a volume resistivity of 1 × 10⁸ Ω·cm or less. The conductive layer has a width corresponding to the first p-type layers 11a and the second p-type layers 11b. Meanwhile, the width of the insulating layers is smaller than the width of the conductive layer, the first p-type layers 11a, and the second p-type layers 11b. The insulating layer on the upper side covers the conductive layer from above on one end side in the width direction of the strip 1 and does not cover the conductive layer on the other end side. The insulating layer on the lower side does not cover the conductive layer on one end side in the width direction of the strip 1 and covers the conductive layer from below on the other end side, contrary to the upper insulating layer. Therefore, on the upper surface of the adhesive layer 13, the conductive region 13a on one end side in the width direction is exposed, and the other end side of the conductive region serves as the insulating region 13b. Meanwhile, on the lower surface of the adhesive layer 13, the conductive region 13a is exposed on the other end side in the width direction, and one end side of the conductive region serves as the insulating region 13b. The conductive regions exposed on both the upper and lower surfaces of the adhesive layer 13 are electrically connected. The strip 1 of the second embodiment is formed so that a potential difference occurs between the p-type layers 11 when a temperature difference is provided between one end side and the other end side in the width direction. Further, in the strip 1 of the second embodiment, the p-type layers 11 are electrically connected to each other so that directions of voltages generated in the p-type layers 11 are aligned in one direction of the conductive path.

In the second embodiment, the case where a plurality of p-type layers 11 constituted by the strip-shaped thermoelectric conversion materials are included is described as an example, but also in the case where a unileg-type thermoelectric transducer is formed by a plurality of n-type layers 12, the aspect shown in Fig. 3 as an example can be employed. Descriptions for examples of materials for forming the p-type layers 11, the n-type layers 12, and the adhesive layers 13, the thickness thereof, and the like are the same as those in the first embodiment, and therefore detailed descriptions will not be repeated. The thermoelectric transducer of the present invention may be of a type in which a unileg type and a bipolar type coexist, and the strip may be partly of a unileg type and the remaining part may be of a bipolar type. That is, the present invention may have two or more p-type layers that are adjacent in the stacking direction or may have two or more n-type layers that are adjacent in the stacking direction. In the present invention, various modifications can be added also to the aspect shown in Fig. 3 as an example.

### Examples

Next, the present invention will be described further in detail by way of examples. However, the present invention is not limited to these examples.

### (Example)

On the assumption that a module for measuring the temperature of human body surfaces outdoors is formed, a thermoelectric transducer to be included in the module was designed. First, p-type layers and n-type layers were formed using a strip-shaped single layer carbon nanotube (bucky paper) having a width of 3 mm, and adhesive layers having insulating regions and conductive regions were formed between these layers, to form pairs of the p-type layers and the n-type layers. 50 pairs were stacked to fabricate a strip having a thickness of 0.75 mm. The strip was wound around a round bar having a diameter of 18 mm, to fabricate a hollow disk-shaped wound body (thermoelectric transducer) with an outer diameter of 56.43 mm. The obtained wound body had softness since the constituents had flexibility and exhibited the followability to curved surfaces such as human body surfaces. The contact area of the thermoelectric transducer with the human body was 2,500 mm². In this area, the occupation ratio of the thermoelectric conversion materials was 60% (effective area: 1,500 mm²). In the case where a temperature difference of about 4.2°C was obtained between the high temperature side (human body side) and the low temperature side (outside air side), the thermoelectric transducer generated an electric power of about 0.46 mW.

### (Comparative Example)

### (Case 1)

For obtaining the same output as in Example using an inorganic sintered body, a 50-mm square (2,500 mm²) sintered block needs to be fabricated, for example. However, it is difficult to fabricate a sintered block itself when it has a size as large as 50-mm square. Moreover, even if a 50-mm square block could be fabricated, such a block cannot be deformed along human body surfaces, and therefore it may be difficult to measure the temperature of body surfaces accurately.

### (Case 2)

Since an about 10-mm square sintered block can be fabricated using an inorganic sintered body, a thermoelectric transducer with which the same output as in Example is obtainable can be fabricated, for example, by connecting a plurality of 10-mm square sintered blocks in series, separately from the block shown in "case 1". However, in this case, it is difficult to ensure a sufficient reliability in the electric connection of the sintered blocks to each other. Further, in this thermoelectric transducer, the softness as exerted by the thermoelectric transducer of Example cannot be expected since each sintered block itself is hard, though the followability to curved surfaces may be improved, as compared with the 50-mm square sintered block of "case 1".

### (Case 3)

In conventional sheet-type devices in which p-type devices and n-type devices are arrayed on a substrate film, and a plurality of p-type devices and n-type devices are arrayed vertically and laterally in the plane direction, it is difficult to provide a temperature difference between the high temperature side and the low temperature side. Even if a temperature difference of about 0.1°C is obtained between the high temperature side and the low temperature side, for setting the occupied area of the thermoelectric transducer to 1,500 mm² in the same manner as in Example, 2,000 or more pairs of p-type devices and n-type devices need to be formed within the region of 1,500 mm² in the case of sheet-type devices. In order to form the aforementioned number of pairs within such a space, it is necessary to make p-type devices and n-type devices exceptionally small to the extent impractical to fabricate. That is, it is found to be difficult for conventional sheet-type devices to generate high electromotive force as in the thermoelectric transducer of Example.

### (Case 4)

When a consideration is given to the practical size of the p-type devices and the n-type devices in the thermoelectric transducer of "case 3", the contact area of the thermoelectric transducer with human bodies needs to be 40 or more times (100,000 mm² or more) larger than that in Example, which is not suitable for practical use.

As also seen from the above, a thermoelectric transducer with excellent output can be provided according to the present invention.

### REFERENCE SIGNS LIST

1: Strip
10: Pair part
11: p-type layer
12: n-type layer
13: Adhesive layer
13a: Conductive region
13b: Insulating region
100: Body

## Claims

1. A thermoelectric transducer comprising:
a strip configured to perform thermoelectric conversion, wherein
the strip comprises a plurality of thermoelectric conversion layers each formed by a strip-shaped thermoelectric conversion material and has a layer structure in which the plurality of thermoelectric conversion layers are stacked,
each adjacent ones of the thermoelectric conversion layers in the stacking direction are electrically connected to each other to form a conductive path passing through the plurality of thermoelectric conversion layers,
the plurality of thermoelectric conversion layers are electrically connected so that, when a temperature difference is provided between one end side and the other end side in the width direction of the strip, a potential difference occurs therebetween, and directions of voltages generated due to the potential difference are aligned in one direction of the conductive path, and
the strip has flexibility.

2. The thermoelectric transducer according to claim 1, wherein
the strip comprises a plurality of p-type layers and a plurality of n-type layers as the thermoelectric conversion layers and has a layer structure in which the p-type layers and the n-type layers are alternately stacked,
each adjacent ones of the p-type layers and the n-type layers in the stacking direction are electrically connected at either end in the width direction, and
the connected points are arranged along the stacking direction alternately on one end side and the other end side in the width direction.

3. The thermoelectric transducer according to claim 2, wherein
the strip comprises:
a pair part comprising one set of a p-type layer and an n-type layer that are electrically connected on one end side in the width direction,
another pair part that is adjacent to the pair part in the stacking direction, and
an adhesive layer configured to bond the pair parts to each other, wherein
the adhesive layer has a conductive region formed by an electrically conductive adhesive on the other end side in the width direction that is opposite to the side on which the p-type layers and the n-type layers are electrically connected to each other within the pair parts, and
the pair parts are electrically connected to each other by the conductive region.

4. The thermoelectric transducer according to claim 3, wherein
each of the pair parts further comprises an adhesive layer configured to bond the p-type layer and the n-type layer to each other, between the p-type layer and the n-type layer,
the adhesive layer comprises a conductive region formed by an electrically conductive adhesive on one end side in the width direction of the strip, and
the p-type layer and the n-type layer are electrically connected to each other by the conductive region on one end side in the width direction.
